Europäisches Patentamt

European Patent Office

Office européen des brevets

(19)

(11) Numéro de publication : **0 290 322 B1**

# FASCICULE DE BREVET EUROPEEN

(12)

(45) Date de publication du fascicule du brevet :
**02.01.92 Bulletin 92/01**

(51) Int. Cl.⁵ : **C30B 11/00,** C30B 35/00

(21) Numéro de dépôt : **88401031.5**

(22) Date de dépôt : **27.04.88**

(54) **Cartouche en matériaux composites pour dispositif d'élaboration de monocristaux.**

(30) Priorité : **27.04.87 FR 8705942**

(43) Date de publication de la demande :
**09.11.88 Bulletin 88/45**

(45) Mention de la délivrance du brevet :
**02.01.92 Bulletin 92/01**

(84) Etats contractants désignés :
**AT BE DE ES FR GB IT NL SE**

(56) Documents cités :
DE-A- 3 337 630
FR-A- 2 329 611
FR-A- 2 345 253
US-A- 3 556 893
US-A- 4 099 924

(56) Documents cités :
US-A- 4 472 476
PATENT ABSTRACTS OF JAPAN, vol. 10, no.
28 (C-326)[2085], 4 février 1986, page 102 C
326; & JP-A-60 180 988 (RIGAKU DENKI
KOGYO K.K.) 14-09-1985

(73) Titulaire : **SOCIETE EUROPEENNE DE
PROPULSION
24 rue Salomon de Rothschild
F-92150 Suresnes (FR)**

(72) Inventeur : **Valentian, Dominique
Forêt de Vernon
F-27207 Vernon (FR)**

(74) Mandataire : **Thévenet, Jean-Bruno et al
Cabinet BEAU DE LOMENIE 55 rue
d'Amsterdam
F-75008 Paris (FR)**

**Description**

La présente invention a pour objet une cartouche en matériaux composites pour dispositif d'élaboration de monocristaux, en solidification unidirectionnelle notamment par la méthode de Bridgman ou en dépôt en phase vapeur.

La solidification orientée de matériaux métalliques et de semiconducteurs peut avoir lieu au sol ou dans l'espace, en microgravité.

Les cartouches utilisées pour contenir le matériau à fondre, notamment celles utilisées dans l'espace en état d'apesanteur, comprennent une double paroi, à savoir une enveloppe externe métallique assurant les fonctions de tenue mécanique, d'étanchéité et de protection contre les défaillances du creuset, et un creuset proprement dit qui contient le matériau à fondre, présente des caractéristiques physique et chimique compatibles avec celles de l'échantillon fondu, ainsi qu'une conductivité thermique qui est de l'ordre de grandeur de celle de l'échantillon afin de limiter la déformation des lignes de flux thermique, mais ne présente aucune caractéristique mécanique garantie.

La présence d'une enveloppe externe métallique, destinée à assurer une protection contre l'effusion de vapeurs en cas de rupture du creuset interne, contribue à déformer les lignes de flux thermique dans l'échantillon, ce qui nuit à la qualité du monocristal obtenu. Par ailleurs, la mise en oeuvre de parois doubles ne permet pas de garantir une tenue mécanique et une fiabilité suffisantes aux très hautes températures du fait des problèmes de dilatation et du risque de corrosion de l'enveloppe métallique externe par l'échantillon à fondre qui est souvent très corrosif surtout s'il s'agit d'un semi-conducteur. Par ailleurs, certains semiconducteurs du type 3-5 (tel que l'arséniure de gallium) ou du type 2-6 comportent des composés très toxiques et impliquent que l'intégralité de la structure de la cartouche soit fiable, ce qui peut difficilement être le cas si la cartouche est elle-même constituée par plusieurs parois successives.

On connait par ailleurs, notamment par le document US-A-4 472 476, des pièces en matériaux composites carbone-carbone, munies de plusieurs revêtements comprenant un premier revêtement de SiC puis un second revêtement de $Si_3N_4$, afin de limiter la dégradation par oxydation des pièces en matériaux composites aux hautes températures. De tels types de matériaux n'ont cependant pas été utilisés dans la fabrication de cartouches utilisées pour contenir un matériau à fondre.

La présente invention vise à remédier aux inconvénients précités des cartouches de l'art antérieur et à réaliser notamment un meilleur contrôle du front de fusion permettant d'obtenir des monocristaux de meilleure qualité, tout en assurant une tenue mécanique et une fiabilité à chaud supérieures à celles des cartouches de l'art antérieur.

Ces buts sont atteints grâce à une cartouche en matériaux composites pour dispositif d'élaboration de monocristaux, caractérisée en ce qu'elle comprend une paroi cylindrique unique réalisée en matériaux composites pour assurer les fonctions de tenue mécanique et d'adaptation de la conductivité thermique à celle de l'échantillon, et munie d'un revêtement intérieur intimement lié pour assurer les fonctions d'étanchéité, de compatabilité physique et chimique et de non contamination de l'échantillon, en ce que la paroi unique est réalisée à partir de fibres de carbone ou de fibres de carbure de silicium imprégnées de carbone ou de carbure de silicium et en ce que le revêtement intérieur est constitué par plusieurs dépôts élémentaires superposés comprenant du carbure de silicium et un ou plusieurs matériaux constitués par $SiO_2$, $Si_3N_4$, BN (nitrure de bore pyrolytique), les matériaux connus sous la marque déposée SiAlON réalisés à partir de $Si_3N_4$ et $Al_2O_3$, ainsi que les borures et nitrures des métaux de transition tels que $ZrB_2$, $TiB_2$, TiN, ZrN.

D'autres caractéristiques et avantages de l'invention ressortiront de la description de modes particuliers de réalisation donnés à titre d'exemples en référence aux dessins annexés sur lesquels :

— la figure 1 est une vue schématique en coupe axiale d'un four à tirage selon la méthode de Bridgman dans lequel peut être utilisée une cartouche selon la présente invention,

— la figure 2 est une vue en coupe axiale d'une partie du four de la figure 1 dans lequel est engagée une cartouche classique équipée d'un jeu de pièces amovibles constituées par un anneau de refroidissement et une partie d'une zone adiabatique,

— la figure 3 est une vue analogue à celle de la figure 2, mais montre une partie de four dans lequel est engagée une cartouche conforme à l'invention,

— la figure 4 est une section selon un plan radial d'une cartouche selon la présente invention, qui présente une section intérieure non circulaire, et

— la figure 5 est une vue de détail agrandie montrant en coupe axiale une partie de la paroi de la cartouche selon l'invention représentée sur la figure 3.

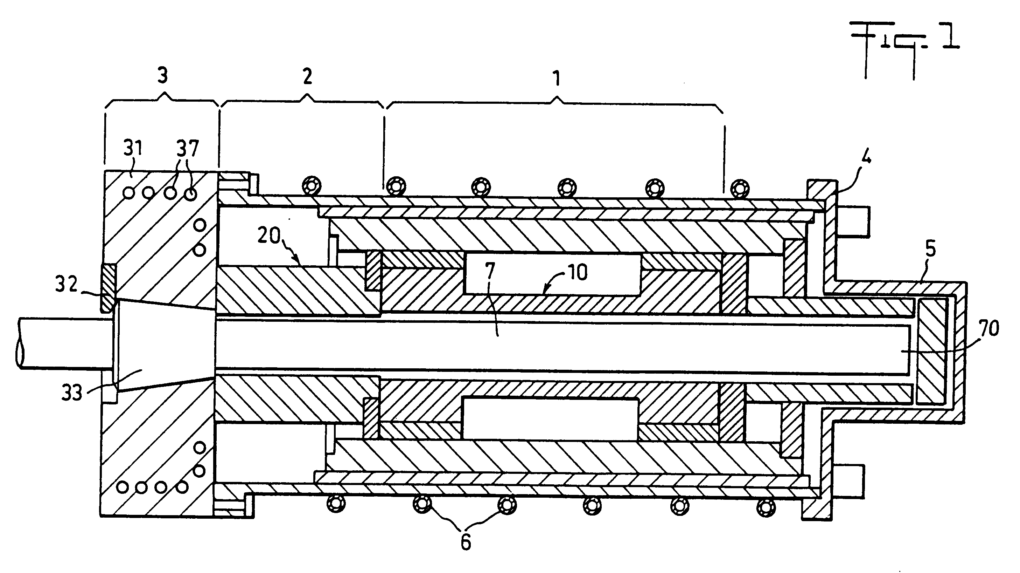

On décrira d'abord brièvement en référence à la figure 1 un exemple de four à tirage permettant de réaliser des matériaux monocristallins notamment semiconducteurs selon la méthode de Bridgman et pouvant recevoir des cartouches telles que celles qui font l'objet de la présente invention.

Un tel four comprend une enceinte 4 à l'intérieur de laquelle on introduit une cartouche 7 contenant le matériau devant faire l'objet d'une fusion puis d'une solidification.

Le four comprend essentiellement une zone de chauffage 1, une zone adiabatique 2 et une zone de refroidissement 3 qui se répartissent dans cet ordre depuis l'extrémité 5 du four opposée à l'extrémité du four par laquelle est introduite puis retirée la cartouche 7.

La zone de chauffage 1 comprend des moyens de chauffage 10, par exemple électrique permettant de faire entrer un flux de chaleur dans l'échantillon à fondre. Des moyens 6 de refroidissement des parois externes du four sont disposés autour de l'enceinte 4 au niveau de la zone de chauffage 1 et de la zone adiabatique 2. Ces moyens de refroidissement peuvent comprendre par exemple des conduits disposés en hélice autour de l'enceinte 4 et parcourus par un fluide de refroidissement.

La zone adiabatique 2 comprend un bloc 20 disposé autour de la cartouche 7 et destiné à conférer au flux thermique à l'intérieur de l'échantillon un caractère essentiellement unidirectionnel. Le front de solidification qui constitue l'interface entre la phase liquide de l'échantillon formée dans la zone de chauffage 1 et la phase solide formée grâce à l'influence de la zone de refroidissement 3, est situé à l'intérieur de la zone adiabatique 2. La planéité du front de solidification et la diminution corrélative de la quantité de défauts dans le monocristal produit seront d'autant meilleures que le caractère unidirectionnel du flux thermique sera plus marqué.

La zone de refroidissement 3 ou puits de chaleur peut être couplée radiativement ou conductivement à la cartouche 7 et peut comprendre un bloc 31 percé de canaux 37 à l'intérieur desquels circule un liquide de refroidissement tel que de l'eau. Un anneau de refroidissement 33 de forme tronconique coaxial à la cartouche 7 peut être introduit dans la zone de refroidissement 3 à l'intérieur du bloc 31 lors de l'introduction de la cartouche 7 à l'intérieur du four. Une cale amovible 32 permet alors d'immobiliser l'anneau 33 à l'intérieur du bloc 31 lors du retrait de la cartouche 7 en cours de l'opération de tirage proprement dite qui permet de réaliser une solidification de l'échantillon fondu par déplacement relatif contrôlé de la cartouche 7 par rapport à la zone de chauffage 1.

La cartouche 7 est de forme essentiellement tubulaire et se trouve obturée à son extrémité froide tandis que l'autre extrémité 70 est compatible avec l'utilisation de dispositifs classiques de compensation de volume (par exemple de type ressort et piston) nécessités par les différences de densité entre la phase liquide et la phase solide.

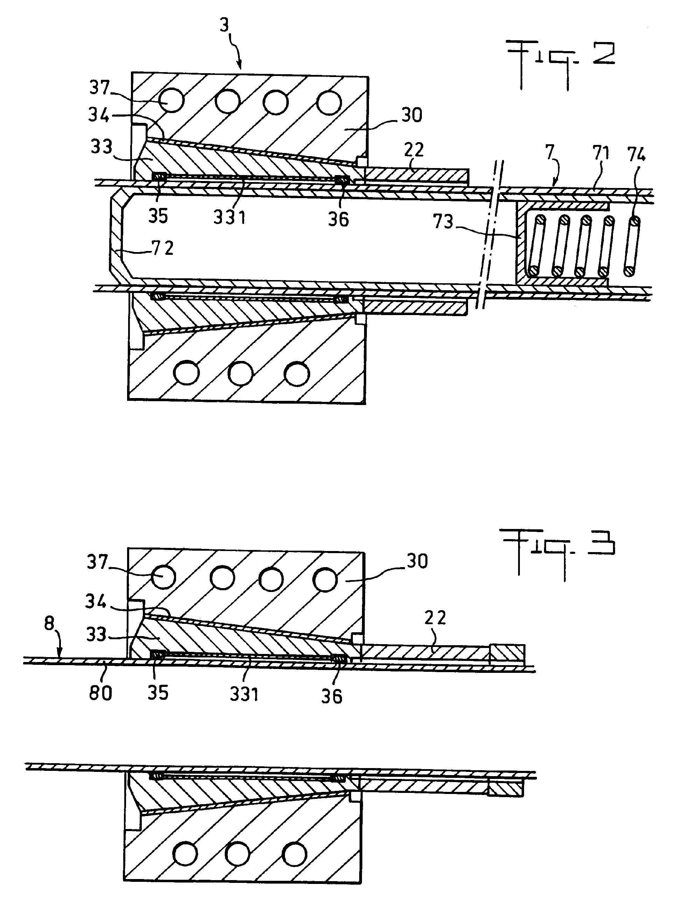

La figure 2 montre de façon plus détaillée une cartouche 7 de conception traditionnelle, dont on a représenté d'une part, l'extrémité haute température munie d'un dispositif de compensation de dilatation constitué d'un piston 73 et d'un ressort 74 en matériau réfractaire, et d'autre part l'extrémité basse température disposée dans le corps 30 du puits de chaleur 3.

L'anneau de refroidissement 33 de forme tronconique introduit dans le corps 30 du puits de chaleur avec la cartouche 7 définit autour de la cartouche 7, de façon connue en soi, un anneau de métal liquide 331 dans un espace annulaire délimité par deux joints 35, 36 placés aux deux extrémités de l'anneau de refroidissement 33. Un joint thermique 34 est également disposé à la jonction entre le corps 30 et l'anneau 33 du côté opposé à la zone adiabatique, qui peut elle-même comprendre une partie amovible 22 rendue solidaire de l'anneau de refroidissement 33.

Sur la figure 2, on voit que la cartouche 7 comprend un creuset interne 72 qui est en contact avec le matériau de l'échantillon à fondre et présente donc des caractéristiques physiques et chimiques compatibles avec celles de l'échantillon, ainsi qu'une conductivité thermique qui est de l'ordre de grandeur de celle de l'échantillon afin de limiter la déformation des lignes de flux thermique. Ce creuset interne 72 adapté à l'échantillon ne présente cependant aucune caractéristique mécanique garantie. C'est pourquoi, de façon traditionnelle, le creuset proprement dit 72 est disposé à l'intérieur d'une enveloppe métallique externe 71 tubulaire qui assure la tenue mécanique de la cartouche 7 et protège contre l'effusion de vapeurs en cas de rupture du creuset interne 72. La présence d'une enveloppe métallique externe 71 contribue cependant à déformer les lignes de flux dans l'échantillon et ne permet donc pas d'obtenir un monocristal de très grande qualité.

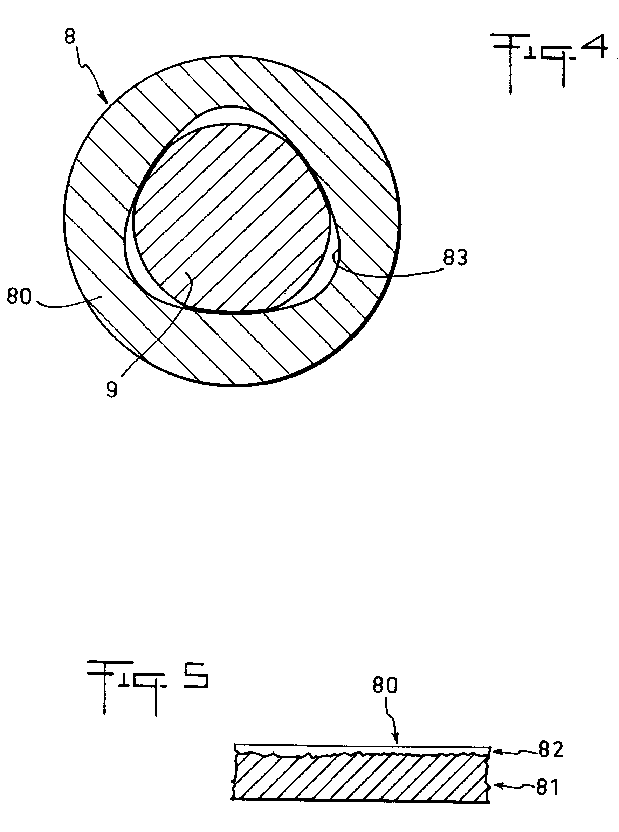

La figure 3 montre une cartouche conforme à la présente invention qui a été substituée à la cartouche traditionnelle 7 à l'intérieur d'un four dont la structure peut par ailleurs rester identique à celle des figures 1 et 2. La cartouche 8 selon l'invention comprend une seule paroi 80 réalisée en matériaux composites et par là-même capable d'assurer à la fois les fonctions de tenue mécanique, d'étanchéité, de compatibilité avec l'échantillon et de conductivité thermique contrôlée.

La contention de l'échantillon à fondre est ainsi assurée par un circuit 8 de forme essentiellement cylindrique réalisé en matériau composite qui peut comprendre des fibres de carbone, des fibres de carbure de silicium, du carbone, du carbure de silicium.

L'adaptation de la conductivité thermique de l'ensemble de la cartouche à celle de l'échantillon (qui peut être réalisée de façon précise) permet d'éviter la déformation des lignes de flux dans l'échantillon, donc d'obtenir un front de solidification plus plan que dans les solutions conventionnelles.

La conductivité thermique de la cartouche est ajustée en agissant sur la texture du tissu composite, la nature de la fibre (carbone ou carbure de silicium) et le type d'imprégnation (phase gazeuse ou liquide).

A titre d'exemple un composite carbone-carbone tel que celui connu sous la marque déposée SEPCARB présente une conductivité thermique élevée tandis qu'un composite carbure de silicium-carbure de silicium tel que celui connu sous la marque déposée CERASEP présente une faible conductivité thermique.

Le matériau composite de par sa structure prévient la propagation de criques et présente à chaud des propriétés mécaniques garanties. La cartouche 8 peut ainsi présenter par sa structure de base une grande sécurité et une bonne résistance aux sollicitations mécaniques à haute température (vibrations, pression interne et contraintes thermiques), du fait de sa résistance au fluage et de son énergie de rupture élevée.

La fonction étanchéité de la cartouche 8 à paroi unique 80 peut être réalisée par un revêtement intérieur 82 de préférence déposé sur la structure composite de base 81 (figure 5) par l'un des procédés suivants : dépôt physique en phase vapeur, dépôt chimique en phase vapeur, évaporation sous vide, pulvérisation cathodique, dépôt ionique en phase vapeur, pressage isostatique à chaud, frittage, vitrification.

Le revêtement intérieur étanche 82 comprend du carbure de silicium et peut être formé de plusieurs dépôts élémentaires superposés. Par exemple le revêtement intérieur 82 peut comprendre les combinaisons suivantes de dépôts : $SiC + SiO_2$, $SiC + Si_3N_4$ ou $SiC + SiAlON$ où $SiAlON$ constitue une marque déposée de la société LUCAS désignant des combinaisons de $Si_3N_4$ et $Al_2O_3$. Il est encore possible de combiner le carbure de silicium avec le nitrure de bore pyrolytique BN ainsi que les borures et nitrures des métaux de transition tels que $ZrB_2$, $TiB_2$, TiN, ZrN.

Le matériau composite de base 81 et le revêtement intérieur étanche 82 de la cartouche 8 combinent leurs propriétés pour assurer simultanément un meilleur contrôle du front de fusion, une tenue mécanique, une étanchéité et une fiabilité à chaud améliorées.

La cartouche 8 selon l'invention peut coopérer avec des dispositifs classiques de compensation de volume nécessités par les différences de densité entre la phase liquide et la phase solide de l'échantillon. Un dispositif de compensation de volume peut ainsi comprendre un ressort et un piston analogues aux éléments 73, 74 représentés sur la figure 2.

La cartouche 8 peut de par sa structure être facilement adaptée pour présenter une section interne 83 non circulaire (figure 4) tout en assurant une bonne résistance à la pression intérieure. Ceci permet par exemple d'assurer avec un matériau fondu 9 non mouillant le confinement de la phase liquide par gradient de tension superficielle en microgravité. Toutefois, pour la plupart des applications, il est préférable que la cartouche 8 présente une section interne circulaire.

La cartouche 8 en composites peut être utilisée aussi bien en solidification unidirectionnelle selon la méthode de Bridgman qu'en dépôt en phase vapeur.

La cartouche 8 est aussi bien adaptée à des expériences en microgravité dans l'espace qu'à des productions industrielles à terre.

La température de service de la cartouche 8 peut atteindre 2000 degrés C.

## Revendications

1. Cartouche en matériaux composites pour dispositif d'élaboration de monocristaux, caractérisée en ce qu'elle comprend une paroi cylindrique unique (80) réalisée en matériaux composites pour assurer les fonctions de tenue mécanique et d'adaptation de la conductivité thermique à celle de l'échantillon et munie d'un revêtement intérieur (82) intimement lié pour assurer les fonctions d'étanchéité, de compatibilité physique et chimique et de non contamination de l'échantillon, en ce que la paroi unique (80) est réalisée à partir de fibres de carbone ou de fibres de carbure de silicium imprégnées de carbone ou de carbure de silicium, et en ce que le revêtement intérieur (82) est constitué par plusieurs dépôts élémentaires superposés comprenant du carbure de silicium et un ou plusieurs des matériaux constitués par $SiO_2$, $Si_3N_4$, BN (nitrure de bore pyrolytique), les matériaux connus sous la marque déposée SiAlON réalisés à partir de $Si_3N_4$ et $Al_2O_3$, ainsi que les borures et nitrures des métaux de transition tels que $ZrB_2$, $TiB_2$, TiN, ZrN.

2. Cartouche selon la revendication 1, caractérisée en ce qu'elle présente une section interne de forme circulaire.

3. Cartouche selon la revendication 1 ou la revendication 2, caractérisée en ce qu'elle comprend un dispositif de compensation de dilatation incorporé du côté haute température.

## Claims

1. Cartridge in composite materials for a device for making monocrystals, characterized in that it comprises a single cylindrical wall (80) made of composite materials in order to simultaneously provide mechanical strength and matching of its thermal conductivity to the thermal conductivity of the sample, and having an inner lining (82) intimately bonded thereto for ensuring the functions of sealing, physical and chemical compatibility and no-contamination of the sample, and in that the single wall (80) is made from carbon or silicon carbide fibers impregnated with carbon or silicon carbide, and in that the inner lining (82) is constituted by a plurality of superposed elementary deposits comprising silicon carbide and one or more of the materials constituted by : $SiO_2$, $Si_3N_4$, BN (pyrolytic boron nitride), the materials known under the registered trademark

SiAlON made from $Si_3N_4$ and $Al_2O_3$, as well as borides and nitrides of transition metals such as $ZrB_2$, $TiB_2$, TiN, ZrN.

2. Cartridge according to claim 1, characterized in that it has an internal section of circular shape.

3. Cardridge according to claim 1 or claim 2, characterized in that it comprises an expansion-compensating device incorporated at its high temperature end.

## Patentansprüche

1. Einsatz aus Verbundwerkstoffen für eine Einrichtung zum Aufbereiten von Monokristallen, dadurch gekennzeichnet, daß er eine einzige zylindrische Wand (80) umfaßt, die zur Sicherung der Funktionen des mechanischen Verhaltens und der Anpassung der Wärmeleitfähigkeit an jene der Probe aus Verbundwerkstoffen gefertigt und mit einer festverbundenen Innenauskleidung (82) zur Sicherung der Funktionen der Dichtheit, der physikalischen und chemischen Kompatibilität und der Nichtkontaminierung der Probe versehen ist, daß die einzige Wand (80) aus Kohlenstoffasern oder aus Siliziumkohlenstofffasern, die mit Kohlenstoff oder Siliziumkohlenstoff imprägniert sind, gefertigt ist, und daß die Innenauskleidung (82) durch mehrere übereinander angebrachte elementare Niederschläge, umfassend Siliziumkohlenstoff und ein oder mehrere Materialien, bestehend aus $SiO_2$, $Si_3N_4$, BN (pyrolytischem Bornitrid), den unter der registrierten Marke SiAlON bekannten Materialien aus $Si_3N_4$ und $Al_2O_3$ sowie den Boriden und Nitriden der Übergangsmetalle, wie $ZrB_2$, $TiB_2$, TiN, ZrN, gebildet ist.

2. Einsatz nach Anspruch 1, dadurch gekennzeichnet, daß er einen kreisförmigen Innenquerschnitt aufweist.

3. Einsatz nach Anspruch 1 oder 2, dadurch gekennzeichnet, daß er eine auf der Hochtemperaturseite eingebaute Einrichtung zum Dehnungsausgleich umfaßt.

Fig. 1

Fig. 2

Fig. 3

8

Fig.4

8

80

9

83

Fig. 5

80

82

81